# EUROPEAN PATENT APPLICATION

(11) **EP 3 611 812 A1**
(43) Date of publication of application: **19.02.2020**
(21) Application number: 18818779.3
(22) Date of filing: 15.05.2018
(51) Int. Cl.: H01S 5/183

(54) **SURFACE-EMITTING SEMICONDUCTOR LASER AND SENSING MODULE**

(30) Priority: 15.06.2017 JP 2017117852
(71) Applicant: Sony Semiconductor Solutions Corporation, Atsugi-shi, Kanagawa 243-0014 (JP)
(72) Inventor: NAKATA, Hidehiko, Kikuchi-gun Kumamoto 869-1102 (JP); FURUSHIMA, Yuji, Kikuchi-gun Kumamoto 869-1102 (JP); MASUI, Yuji, Atsugi-shi Kanagawa 243-0014 (JP)
(74) Representative: D Young & Co LLP
(86) International application number: PCT/JP2018/018743
(87) International publication number: WO 2018/230230

(57) **Abstract**

A surface-emitting semiconductor laser includes a first emission region that outputs first light, and a second emission region that is provided separately from the first emission region, includes a phase shift section, and outputs second light. A far field pattern of the first light and a far field pattern of the second light are different from each other.

## Description

### Technical Field

The present technology relates to a surface-emitting semiconductor laser having a plurality of emission regions, and a sensing module.

### Background Art

The development of surface-emitting semiconductor lasers each having a plurality of emission regions is progressing (for example, see PTL 1). The surface-emitting semiconductor lasers each include, for example, a vertical cavity surface emitting laser (VCSEL).

### Citation List

### Patent Literature

PTL 1: Japanese Unexamined Patent Application Publication No. 2005-116933

### Summary of the Invention

Surface-emitting semiconductor lasers are desired to reduce the difference in light intensities depending on directions of radiation angles and bring an intensity distribution of a far field pattern (FFP) closer to a uniform distribution.

Therefore, it is desirable to provide a surface-emitting semiconductor laser that makes it possible to bring an intensity distribution of a far field pattern closer to a uniform distribution and a sensing module including the surface-emitting semiconductor laser.

A first surface-emitting semiconductor laser according to an embodiment of the present technology includes a first emission region that outputs first light, and a second emission region that is provided separately from the first emission region, includes a phase shift section, and outputs second light. A far field pattern of the first light and a far field pattern of the second light are different from each other.

According to the first surface-emitting semiconductor laser of an embodiment of the present technology, the phase shift section is provided in the second emission region, thus the second light of the far field pattern different from the far field pattern of the first light is outputted from the second emission region.

A second surface-emitting semiconductor laser according to an embodiment of the present technology includes a first current injection region, and a second current injection region that is provided separately from the first current injection region, has a size different from a size of the first current injection region. A far field pattern of first light outputted from the first current injection region and a far field pattern of second light outputted from the second current injection region are different from each other.

According to the second surface-emitting semiconductor laser of an embodiment of the present technology, the second current injection region differs in size from the first current injection region, thus the second light of the far field pattern different from the far field pattern of the first light is outputted from the second current injection region.

A third surface-emitting semiconductor laser according to an embodiment of the present technology includes a first mesa region that is provided with a first current injection region, and outputs first light, and a second mesa region that is provided with a second current injection region, has a planar shape different from a planar shape of the first mesa region, and outputs second light. A far field pattern of the first light and a far field pattern of the second light are different from each other.

According to the third surface-emitting semiconductor laser of an embodiment of the present technology, the second mesa region differs in planar shape from the first mesa region, thus the second light of the far field pattern different from the far field pattern of the first light is outputted from the second mesa region.

First, second, and third sensing modules according to an embodiment of the present technology respectively include the first, second, and third surface-emitting semiconductor lasers according to an embodiment of the present technology.

According to the first, second, and third surface-emitting semiconductor lasers and the first, second, and third sensing modules of an embodiment of the present technology, the far field pattern of the first light and the far field pattern of the second light are different from each other; therefore, superimposition of the first light and the second light makes it possible to reduce the difference in light intensities depending on the directions of radiation angles. Accordingly, it is possible to bring an intensity distribution of a far field pattern closer to a uniform distribution.

It is to be noted that the contents described above are an example of the present disclosure. The effects of the present disclosure are not limited to those described above, and may be other different effects, or may further include other effects.

### Brief Description of Drawings

[FIG. 1] FIG. 1 is a schematic plan view illustrating a schematic configuration of a semiconductor laser according to a first embodiment of the present technology.
[FIG. 2A] FIG. 2A is a diagram schematically illustrating a cross-sectional configuration along a line A-A' illustrated in FIG. 1.
[FIG. 2B] FIG. 2B is a diagram schematically illustrating a cross-sectional configuration along a line B-B' illustrated in FIG. 1.
[FIG. 3A] FIG. 3A is a diagram illustrating a second light reflection layer-side reflectance of an emission region illustrated in FIG. 2A.
[FIG. 3B] FIG. 3B is a diagram illustrating a second light reflection layer-side reflectance of an emission region illustrated in FIG. 2B.
[FIG. 4] FIG. 4 is a diagram for explaining a fundamental mode oscillation and a higher-order mode oscillation.
[FIG. 5A] FIG. 5A is a diagram illustrating an example of a far field pattern of light outputted from the emission region illustrated in FIG. 2A.
[FIG. 5B] FIG. 5B is a diagram illustrating a planar configuration of the far field pattern illustrated in FIG. 5A.
[FIG. 6] FIG. 6 is a diagram that explains a fundamental mode and a higher-order mode of light outputted from the emission region illustrated in FIG. 2B.
[FIG. 7A] FIG. 7A is a diagram illustrating an example of a far field pattern of light outputted from the emission region illustrated in FIG. 2B.
[FIG. 7B] FIG. 7B is a diagram illustrating a planar configuration of the far field pattern illustrated in FIG. 7A.
[FIG. 8A] FIG. 8A is a cross-sectional view illustrating a process in a method of producing a first mesa region illustrated in FIG. 2A.
[FIG. 8B] FIG. 8B is a cross-sectional view illustrating a configuration of a second mesa region in a process that is the same as a process illustrated in FIG. 8A.
[FIG. 9A] FIG. 9A is a cross-sectional view illustrating a process subsequent to FIG. 8A.
[FIG. 9B] FIG. 9B is a cross-section illustrating a configuration of the second mesa region in a process that is the same as a process illustrated in FIG. 9A.
[FIG. 10A] FIG. 10A is a diagram illustrating an example of a far field pattern of multi-mode light.
[FIG. 10B] FIG. 10B is a diagram illustrating another example of the far field pattern illustrated in FIG. 10A.
[FIG. 11A] FIG. 11A is a schematic plan view illustrating a schematic configuration of a semiconductor laser according to Comparative Example 1.
[FIG. 11B] FIG. 11B is a schematic plan view illustrating a schematic configuration of a semiconductor laser according to Comparative Example 2.
[FIG. 12A] FIG. 12A is a diagram illustrating a far field pattern of light in which respective pieces of light outputted from the emission regions illustrated in FIGs. 2A and 2B are superimposed.
[FIG. 12B] FIG. 12B is a diagram illustrating a planar configuration of the far field pattern illustrated in FIG. 12A.
[FIG. 13] FIG. 13 is a schematic plan view illustrating a schematic configuration of a semiconductor laser according to a second embodiment of the present technology.
[FIG. 14] FIG. 14 is a schematic plan view illustrating a schematic configuration of a semiconductor laser according to a third embodiment of the present technology.
[FIG. 15A] FIG. 15A is a schematic plan view illustrating a configuration of a first mesa region illustrated in FIG. 14.
[FIG. 15B] FIG. 15B is a diagram illustrating a far field pattern of light outputted from the first mesa region illustrated in FIG. 15A.
[FIG. 16A] FIG. 16A is a schematic plan view illustrating a configuration of a second mesa region illustrated in FIG. 14.
[FIG. 16B] FIG. 16B is a diagram illustrating a far field pattern of light outputted from the first mesa region illustrated in FIG. 16A.
[FIG. 17A] FIG. 17A is a schematic cross-sectional view illustrating a schematic configuration of a sensing module including the semiconductor laser illustrated in FIGs. 1, etc.
[FIG. 17B] FIG. 17B is a schematic diagram illustrating a planar configuration of the sensing module illustrated in FIG. 17A.

### Modes for Carrying Out the Invention

In the following, some embodiments of the present technology are described in detail with reference to the drawings. It is to be noted that description is given in the following order.

### 1. First Embodiment

A semiconductor laser in which a phase shift section is provided in, of a plurality of emission regions, some emission regions (second emission regions)

### 2. Modification Example

An example in which, on a side of a second light reflection layer, a phase shift section is higher in reflectance

### 3. Second Embodiment

A semiconductor laser in which of a plurality of current injection regions, some current injection regions (second current injection regions) have a different size

### 4. Third Embodiment

A semiconductor laser in which of a plurality of mesa regions, some mesa regions (second mesa regions) have a different planar shape

### [First Embodiment]

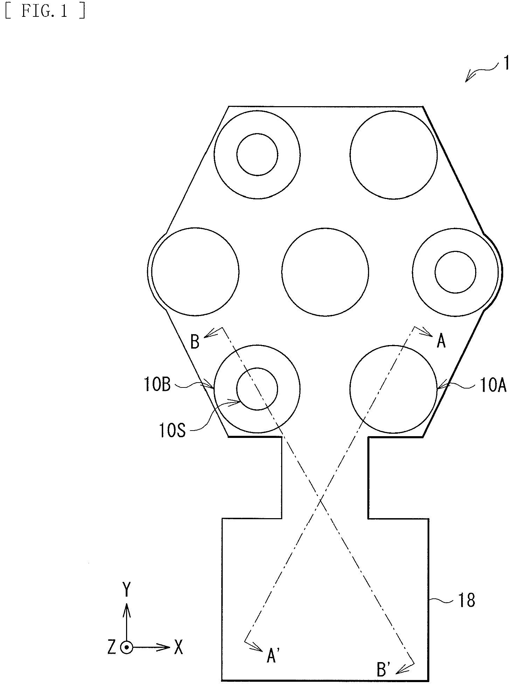

FIG. 1 illustrates a schematic planar configuration of a surface-emitting semiconductor laser (a semiconductor laser 1) according to a first embodiment of the present technology. The semiconductor laser 1 is a VCSEL, and FIG. 1 illustrates a light-output-side planar configuration. The semiconductor laser 1 includes a first mesa region 10A and a second mesa region 10B, and pieces of light are outputted from the first mesa region 10A and the second mesa region 10B without phases thereof being synchronized with each other. The second mesa region 10B includes a phase shift section 10S. Respective planar shapes of the first mesa region 10A, the second mesa region 10B, and the phase shift section 10S, i.e., respective shapes of the first mesa region 10A, the second mesa region 10B, and the phase shift section 10S viewed from a plane parallel to a light output surface are substantially circular. FIG. 1 illustrates an example where the semiconductor laser 1 is provided with four first mesa regions 10A and three second mesa regions 10B; however, the respective numbers of the first mesa regions 10A and the second mesa regions 10B are not limited thereto. The first mesa region 10A and the second mesa region 10B provided in the semiconductor laser 1 are coupled in parallel to one another.

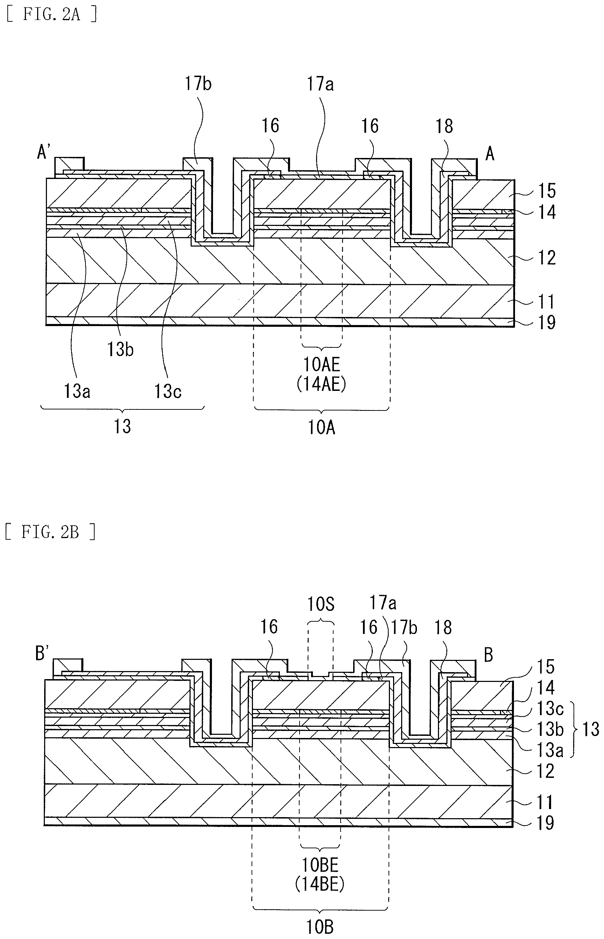

FIG. 2A illustrates a schematic cross-sectional configuration of the semiconductor laser 1 along a line A-A' illustrated in FIG. 1, and FIG. 2B illustrates a schematic cross-sectional configuration of the semiconductor laser 1 along a line B-B' illustrated in FIG. 1. The semiconductor laser 1 has a first light reflection layer 12, a semiconductor layer 13, a current confinement layer 14, and a second light reflection layer 15 in the stated order on a substrate 11. The semiconductor layer 13 includes a first semiconductor layer 13a, an active layer 13b, and a second semiconductor layer 13c in the stated order from a position closer to the first light reflection layer 12. An electrode 16 and a first dielectric film 17a are provided on the second light reflection layer 15. A pad electrode 18 is electrically coupled to the electrode 16, and a second dielectric film 17b is stacked on the first dielectric film 17a. An electrode 19 that is paired with the electrode 16 is provided on a back surface (a surface opposing the surface provided with the first light reflection layer 12) of the substrate 11.

The first mesa regions 10A and the second mesa regions 10B are provided in some regions on the substrate 11, and each have a column-like shape, for example, such as a cylindrical shape. The first mesa region 10A and the second mesa region 10B are formed, for example, by etching from the second light reflection layer 15 to some of the first light reflection layer 12, and the semiconductor layer 13 of the first mesa region 10A and the semiconductor layer 13 of the second mesa region 10B are provided separately from each other. The current confinement layer 14 of the first mesa region 10A is provided with a first current injection region 14AE, and the current confinement layer 14 of the second mesa region 10B is provided with a second current injection region 14BE. The phase shift section 10S is provided in a position that overlaps with a portion of the second current injection region 14BE in a plan view (when viewed from a plane parallel to the surface of the substrate 11, for example, an XY plane in FIG. 1). The phase shift section 10S is provided, for example, in a middle portion of the second current injection region 14BE in the plan view. It is to be noted that in the present specification, the plan view represents a visual direction from a plane parallel to the surface (or the light output surface) of the substrate 11, and the planar shape represents a shape viewed from the plane parallel to the surface (or the light output surface) of the substrate 11.

The substrate 11 includes, for example, a gallium arsenide (GaAs) substrate. The substrate 11 may include indium phosphide (InP), gallium nitride (GaN), indium gallium nitride (InGaN), sapphire, silicon (Si), silicon carbide (SiC), or the like. In a case of using a non-conductive material such as sapphire for the substrate 11, a contact is formed as necessary.

The first light reflection layer 12 on the substrate 11 is a distributed bragg reflector (DBR) disposed on the side of the first semiconductor layer 13a, and is provided uninterruptedly in the first mesa region 10A and the second mesa region 10B. In the first mesa region 10A and the second mesa region 10B, the first light reflection layer 12 is opposed to the active layer 13b with the first semiconductor layer 13a interposed therebetween, and resonates light generated in the active layer 13b between the first light reflection layer 12 and the second light reflection layer 15.

The first light reflection layer 12 has a stacked structure in which low refractive index layers and high refractive index layers are alternately stacked on top of another. For example, the low refractive index layers are each n-type Al_{X1}Ga_{(1-X1)}As (0 < X1 < 1) having an optical film thickness of λ/4, where λ denotes an oscillation wavelength of the semiconductor laser 1. For example the high refractive index layers are each n-type Al_{X2}Ga_{(1-X2)}As (0 ≤ X2 < X1) having an optical film thickness of λ/4.

The semiconductor layer 13 is provided in each of the first and second mesa regions 10A and 10B, and includes, for example, an aluminum gallium arsenide (AlGaAs)-based semiconductor material. The first semiconductor layer 13a is a spacer layer provided between the first light reflection layer 12 and the active layer 13b, and includes, for example, n-type Al_{X3}Ga_{(1-X3)}As (0 ≤ X3 < 1). Examples of an n-type impurity include silicon (Si), selenium (Se), and the like.

The active layer 13b is provided between the first semiconductor layer 13a and the second semiconductor layer 13c. This active layer 13b receives electrons injected from the electrode 16 through the first current injection region 14AE or the second current injection region 14BE and generates induced emission light. For example, undoped Al_{X4}Ga_{(1-X4)}As (0 ≤ X4 < 1) may be used for the active layer 13b. The active layer 13b may have a multi-quantum well (MQW) structure of, for example, GaAs and AlGaAs. The active layer 13b may well have a multi-quantum well structure of InGaAs and AlGaAs.

The second semiconductor layer 13c is a spacer layer provided between the active layer 13b and the current confinement layer 14, and includes, for example, p-type Al_{X5}Ga_{(1-X5)}As (0 ≤ X5 < 1). Examples of a p-type impurity include carbon (C), zinc (Zn), magnesium (Mg), beryllium (Be), and the like.

For example, depending on constituent materials of the substrate 11, the semiconductor layer 13 may include a semiconductor material of an aluminum indium gallium arsenide (AlInGaAs) base, an aluminum gallium indium phosphide (AlGaInP) base, or an aluminum indium gallium nitride (AlInGaN) base.

The current confinement layer 14 between the semiconductor layer 13 and the second light reflection layer 15 is provided in each of the first and second mesa regions 10A and 10B, and the current confinement layer 14 of the first mesa region 10A and the current confinement layer 14 of the second mesa region 10B are separated from each other. A portion of the current confinement layer 14 on the side of the periphery of each of the first and second mesa regions 10A and 10B is caused to have a high resistance and is a current confinement region. The first current injection region 14AE and the second current injection region 14BE are each provided to be surrounded by the current confinement region. By providing such a current confinement layer 14, an electric current injected from the electrode 16 into the active layer 13b is confined, and this makes it possible to increase the current injection efficiency. Accordingly, it is possible to lower a threshold current.

The first current injection regions 14AE and the second current injection regions 14BE are provided separately from one another in the plan view, and the respective planar shapes are, for example, substantially circular. Respective sizes of the first and second current injection regions 14AE and 14BE are, for example, 5 µm or more in diameter, and multi-mode light is outputted from the first mesa regions 10A and the second mesa regions 10B. For example, the diameter of the first current injection region 14AE may be smaller than 5 µm, and single-mode light may be outputted from the first mesa region 10A and multi-mode light may be outputted from the second mesa region 10B. The first current injection regions 14AE and the second current injection regions 14BE are, for example, substantially the same in size, and their difference is, for example, 50% or less. This allows respective densities of current flowing into the first current injection regions 14AE and the second current injection regions 14BE to be substantially the same, and therefore it is possible to make respective emission lifetimes of the first mesa region 10A and the second mesa region 10B substantially the same.

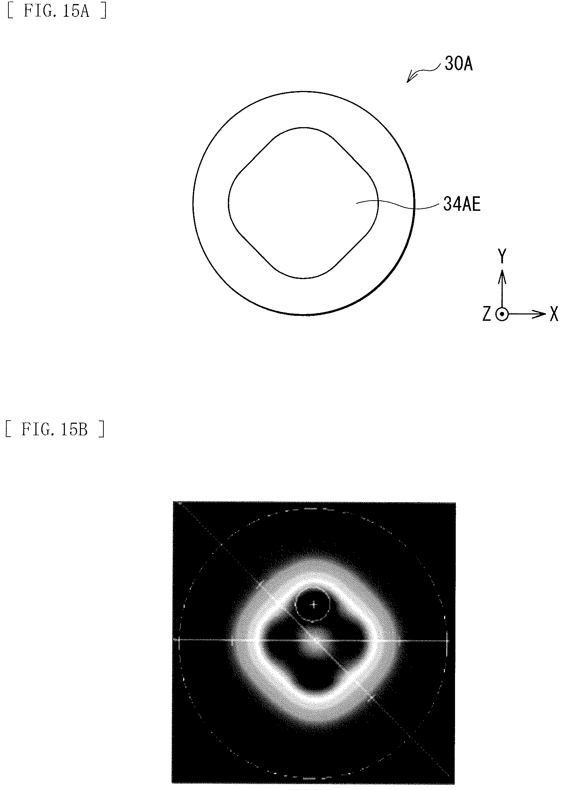

The respective planar shapes of the first current injection region 14AE and the second current injection region 14BE may be, for example, quadrangular (FIG. 15A to be described later). The first current injection region 14AE and the second current injection region 14BE are formed, for example, by oxidizing a portion of the current confinement layer 14, and therefore are likely to be affected by the crystal plane orientation of the substrate 11. Accordingly, the first current injection region 14AE and the second current injection region 14BE may be formed, whose respective planar shapes are different from the respective shapes similar to the first and second mesa regions 10A and 10B. Respective portions of the first and second mesa regions 10A and 10B that overlap with the first and second current injection regions 14AE and 14BE in the plan view are emission regions (emission regions 10AE and 10BE) of the first and second mesa regions 10A and 10B. Here, the emission region 10AE is a specific example of a first emission region according to an embodiment of the present technology, and the emission region 10BE is a specific example of a second emission region according to an embodiment of the present technology. The emission regions 10AE and the emission regions 10BE are disposed separately from each other in the plan view.

The current confinement layer 14 includes, for example, p-type Al_{X6}Ga_{(1-X6)}As (0 ≤ X6 < 1), and a current confinement region is formed by oxidation of this Al_{X6}Ga_{(1-X6)}As from the periphery of each of the first and second mesa regions 10A and 10B. The current confinement region includes, for example, aluminum oxide (Al₂O₃). A portion of the second light reflection layer 15 may be provided between the second semiconductor layer 13c and the current confinement layer 14.

The second light reflection layer 15 is a DBR disposed on the side of the second semiconductor layer 13c, and is provided in each of the first and second mesa regions 10A and 10B. The second light reflection layer 15 of the first mesa region 10A and the second light reflection layer 15 of the second mesa region 10B are separated from each other. The second light reflection layer 15 is opposed to the first light reflection layer 12 with the semiconductor layer 13 and the current confinement layer 14 interposed therebetween. The second light reflection layer 15 has a stacked structure in which low refractive index layers and high refractive index layers are alternately stacked on top of another. For example, the low refractive index layers are each p-type Al_{X1}Ga_{(1-X1)}As (0 < X7 < 1) having an optical film thickness of λ/4. For example, the high refractive index layers are each p-type Al_{X8}Ga_{(1-X8)}As (0 ≤ X8 < X7) having an optical film thickness of λ/4.

The electrode 16 on the second light reflection layer 15 is provided in each of the first and second mesa regions 10A and 10B. The electrode 16 is an annular electrode, and has a light extraction window in the middle portion thereof. This light extraction window of the electrode 16 is provided in a region including a region opposed to the first current injection region 14AE or the second current injection region 14BE. The electrode 16 is electrically coupled to the semiconductor layer 13 through the second light reflection layer 15. The electrode 19 is provided, for example, on the back surface front surface of the substrate 11, and is provided commonly to the first mesa regions 10A and the second mesa regions 10B. The electrodes 16 and 19 include a film of metal, for example, such as gold (Au), germanium (Ge), silver (Ag), palladium (Pd), platinum (Pt), nickel (Ni), titanium (Ti), vanadium (V), tungsten (W), chromium (Cr), aluminum (Al), copper (Cu), zinc (Zn), tin (Sn), indium (In), or the like. The electrode 16 may include a single-layer metal film, or may include a metal film of a stacked structure.

The pad electrode 18 allows the light extraction window of the electrode 16 to be exposed, and is electrically coupled to the electrode 16. The pad electrode 18 is provided from a top surface of the electrode 16 to around each of the first and second mesa regions 10A and 10B through respective side surfaces of the second light reflection layer 15, the current confinement layer 14, and the semiconductor layer 13. On the outside of each of the first and second mesa regions 10A and 10B, a portion of the pad electrode 18 is exposed from the second dielectric film 17b. The pad electrode 18 makes it possible for the semiconductor laser 1 to be electrically coupled to an external electrode or circuit. The pad electrode 18 includes metal, for example, such as titanium (Ti), aluminum (Al), platinum (Pt), gold (Au), nickel (Ni), palladium (Pd), or the like. The pad electrode 18 may include a single-layer metal film, or may include a metal film of a stacked structure. The pad electrode 18 has, for example, a hexagonal portion and a quadrangular portion in the plan view, and the portions are coupled to each other (FIG. 1). For example, the first mesa regions 10A and the second mesa regions 10B are disposed in the hexagonal portion of the pad electrode 18.

The first dielectric film 17a covers a top surface of the second light reflection layer 15 and the respective side surfaces of the second light reflection layer 15, the current confinement layer 14, and the semiconductor layer 13. The first dielectric film 17a is provided between: the respective side surfaces of the second light reflection layer 15, the current confinement layer 14, and the semiconductor layer 13; and the pad electrode 18. The first dielectric film 17a prevents an electrical short, etc. In the first mesa region 10A, the first dielectric film 17a is provided over the entire portion (the light extraction window of the electrode 16) of the top surface of the second light reflection layer 15 that is exposed from the electrode 16. In the second mesa region 10B, the first dielectric film 17a of the phase shift section 10S is removed, and the first dielectric film 17a is provided around the phase shift section 10S.

The second dielectric film 17b is provided on the first dielectric film 17a and on the pad electrode 18, and covers the top surface of the second light reflection layer 15 and the respective side surfaces of the second light reflection layer 15, the current confinement layer 14, and the semiconductor layer 13. The second dielectric film 17b has a role in preventing the pad electrode 18 and the semiconductor layer 13 of each of the first and second mesa regions 10A from being exposed and increasing the moisture resistance of the semiconductor laser 1. In both the first and second mesa regions 10A and 10B, the second dielectric film 17b is provided on the portion (the light extraction window of the electrode 16) of the top surface of the second light reflection layer 15 that is exposed from the electrode 16. The first dielectric film 17a and the second dielectric film 17b include a dielectric material having a refractive index higher than a refractive index of air (about 1.0), and include, for example, silicon nitride (SiN). Respective optical film thicknesses of the first and second dielectric films 17a and 17b are, for example, about an odd multiple of λ/4.

In the first mesa region 10A, the second light reflection layer 15, the first dielectric film 17a, and the second dielectric film 17b are stacked in the stated order on the first current injection region 14AE (the emission region 10AE). In the phase shift section 10S of the second mesa region 10B, the second light reflection layer 15 and the second dielectric film 17b are stacked in the stated order on the second current injection region 14BE (the emission region 10BE); and around the phase shift section 10S, the second light reflection layer 15, the first dielectric film 17a, and the second dielectric film 17b are stacked in the stated order on the second current injection region 14BE. That is, in the emission region 10BE of the second mesa region 10B, the phase shift section 10S and the other portion differ in thickness of the dielectric film (the first dielectric film 17a and the second dielectric film 17b). In other words, in the semiconductor laser 1, the phase shift section 10S is formed by causing the dielectric film on the second light reflection layer 15 to have a different thickness. In the emission region 10BE, the dielectric film of the phase shift section 10S has an optical film thickness of, for example, about an odd multiple of λ/4, and the dielectric film of the other portion has an optical film thickness of, for example, about an even multiple of λ/4.

The phase shift section 10S is provided in a portion, for example, a middle portion of the emission region 10BE. The planar shape of the phase shift section 10S is, for example, substantially circular, and the diameter of the phase shift section 10S is, for example, less than 60% of the maximum diameter of the emission region 10BE. By providing the phase shift section 10S of this size, the effect of a phase shift is fully exerted. Providing the phase shift section 10S makes oscillation of LP21 that is secondary higher-order mode dominant, and oscillation of LP01 that is a fundamental mode is suppressed.

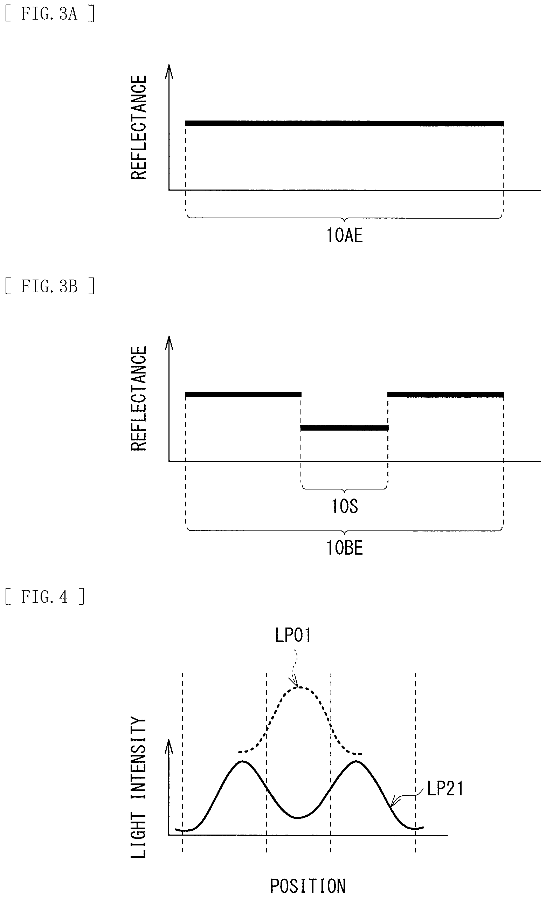

FIG. 3A illustrates the light reflectance of the emission region 10AE on the side of the second light reflection layer 15, and FIG. 3B illustrates the light reflectance of the emission region 10BE on the side of the second light reflection layer 15. The emission region 10AE is high and uniform in light reflectance on the side of the second light reflection layer 15 over the entire region. In the emission region 10BE, light reflectance on the side of the second light reflection layer 15 is lower in the phase shift section 10S than in the other portion of the emission region 10BE. Accordingly, in the phase shift section 10S, for example, oscillation of secondary higher-order mode LP21 becomes dominant. The following describes about this.

As illustrated in FIG. 4, for example, light of a LP01-mode, which is a fundamental mode, and light of a LP21-mode, which is secondary higher-order mode, are outputted from the emission regions 10AE and 10BE. In the LP01-mode, the light intensity is highest in a middle portion of each of the emission regions 10AE and 10BE, and gradually decreases with distance from the middle portion. In the LP21-mode, the light intensity is low in the middle portion of each of the emission regions 10AE and 10BE and high in a peripheral portion of each of the emission regions 10AE and 10BE.

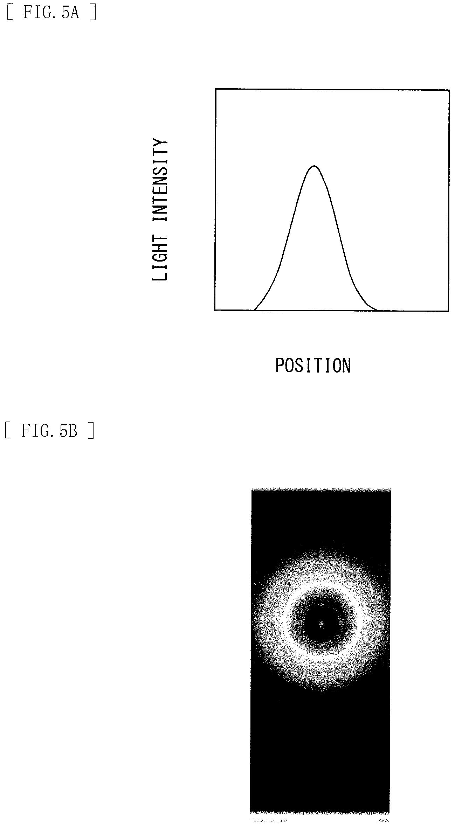

FIGs. 5A and 5B illustrate a far field pattern of light (first light) outputted from the emission region 10AE. The emission region 10AE is high in light reflectance on the side of the second light reflection layer 15 in the entire region; therefore, LP01-mode oscillation occurs before LP21-mode oscillation, and LP01-mode light becomes dominant. That is, a far field pattern in which the middle portion is high in light intensity is formed.

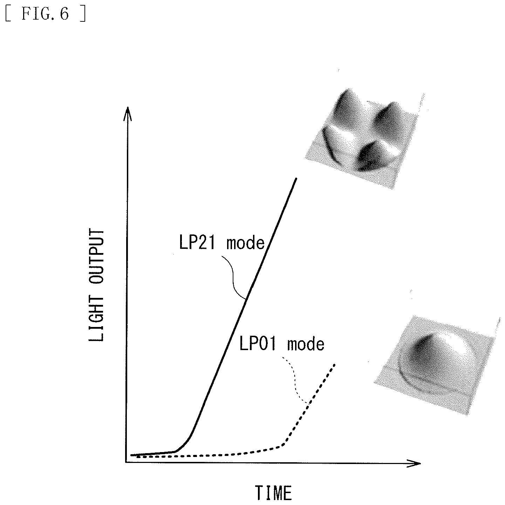

FIG. 6 illustrates respective aspects of LP01-mode and LP21-mode oscillations of light (second light) outputted from the emission region 10BE. In the emission region 10BE, the phase shift section 10S is low in light reflectance on the side of the second light reflection layer 15; therefore, LP01-mode oscillation is suppressed in this way, and LP21-mode light becomes dominant.

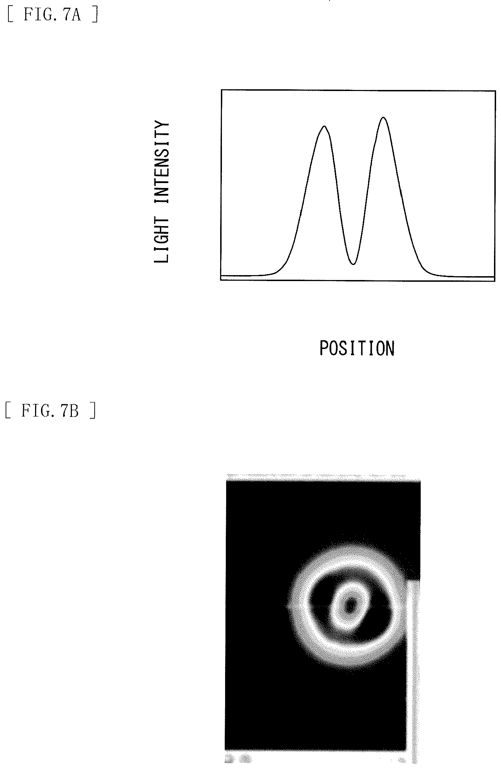

FIGs. 7A and 7B illustrate a far field pattern of light outputted from the emission region 10BE. In the emission region 10BE provided with the phase shift section 10S, a far field pattern in which the middle portion is low in light intensity is formed. That is, the far field pattern of light outputted from the emission region 10BE is different from the far field pattern of light outputted from the emission region 10AE.

In the present embodiment, in this way, of the plurality of emission regions (the emission regions 10AE and 10BE), some emission regions (the emission regions 10BE) are provided with the phase shift section 10S; therefore, pieces of light of different far field patterns are extracted from the emission regions 10AE and 10BE. As will be described in detail later, the semiconductor laser 1 superimposes and outputs the pieces of light of different far field patterns, thereby making it possible to reduce the difference in light intensities depending on the directions of radiation angles.

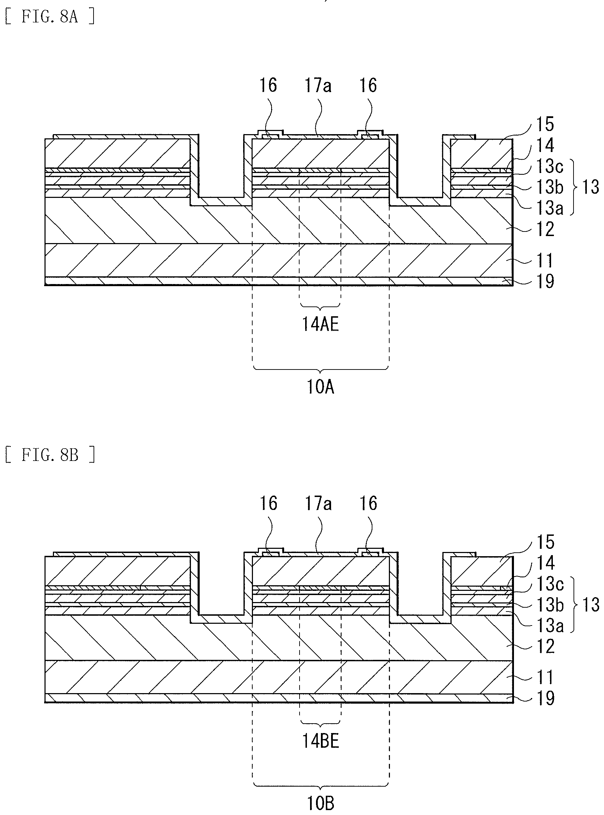

Such a semiconductor laser 1 may be manufactured, for example, as follows (FIGs. 8A to 9B).

First, the first light reflection layer 12, the semiconductor layer 13, the current confinement layer 14, and the second light reflection layer 15 are stacked in the stated order on the substrate 11. Formation of this stacked body is performed, for example, by epitaxial crystal growth using a method such as a molecular beam epitaxy (MBE) method, a metal organic chemical vapor deposition (MOCVD) method, or the like.

Next, a plurality of resist films having, for example, a circular planar shape is formed on the second light reflection layer 15. With the resist films as a mask, the area from the second light reflection layer 15 to some of the first light reflection layer 12 is etched. The etching is performed, for example, by using a reactive ion etching (RIE) method. Thus, the first mesa regions 10A and the second mesa regions 10B are formed. After the etching has been performed, the resist films are removed.

Then, oxidation treatment of the current confinement layer 14 is performed at high temperature in a steam atmosphere. Through this oxidation treatment, a current confinement region is formed over a certain region from the periphery of each of the first and second mesa regions 10A and 10B, and the first current injection region 14AE and the second current injection region 14BE are formed in the middle portions of the first and second mesa regions 10A and 10B, respectively. After that, the annular electrode 16 is formed on the second light reflection layer 15, and the electrode 19 is formed on the back surface of the substrate 11.

Next, as illustrated in FIGs. 8A and 8B, the first dielectric film 17a is formed on the second light reflection layer 15 so as to cover the electrode 16. The first dielectric film 17a is formed to cover a top surface and a side wall of each of the first and second mesa regions 10A and 10B and over around them. The first dielectric film 17a is formed, for example, by a chemical vapor deposition (CVD) method or the like.

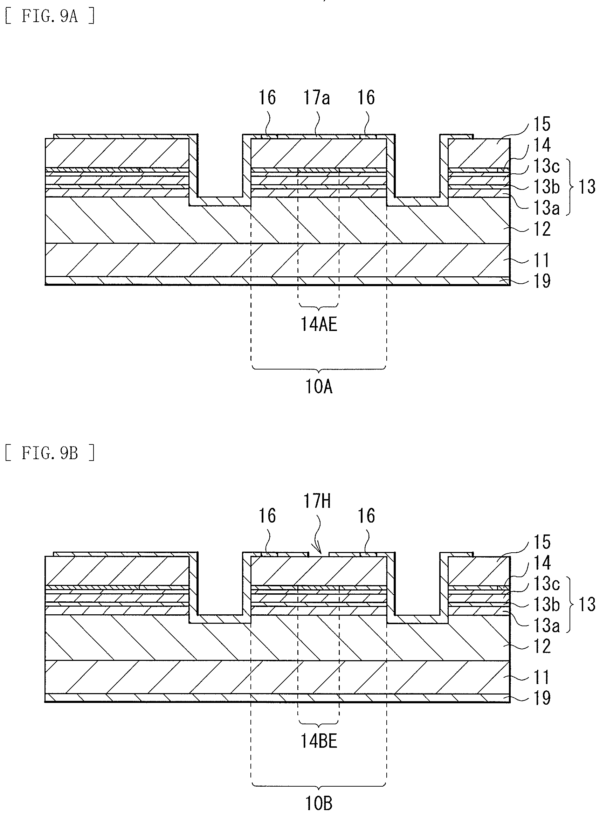

After the first dielectric film 17a has been formed, as illustrated in FIGs. 9A and 9B, the first dielectric film 17a is selectively removed. In the first mesa region 10A, the first dielectric film 17a on the electrode 16 is removed so that the electrode 16 is exposed. In the second mesa region 10B, the first dielectric film 17a on the electrode 16 and a portion of the first dielectric film 17a that overlaps with the middle portion of the second current injection region 14BE in the plan view are removed. Thus, an opening 17H of the first dielectric film 17a for forming the phase shift section 10S is formed. The selective removal of the first dielectric film 17a is performed, for example, by reactive ion etching.

After the first dielectric film 17a has been selectively removed, the pad electrode 18 and the second dielectric film 17b are formed in the stated order. In the emission region 10AE, the first dielectric film 17a and the second dielectric film 17b are stacked and formed on the second light reflection layer 15. In the emission region 10BE, the second dielectric film 17b is provided in the opening 17H of the first dielectric film 17a, and the phase shift section 10S is formed. In the emission region 10BE around the phase shift section 10S, the first dielectric film 17a and the second dielectric film 17b are stacked and formed on the second light reflection layer 15. A portion of the pad electrode 18 is exposed by removing a selective region of the second dielectric film 17b on the outside of each of the first and second mesa regions 10A and 10B, for example, by etching.

After the second dielectric film 17b has been formed, the substrate 11 is thinned down to a desired thickness. Finally, an electrode (not illustrated) that is paired with the electrode 16 is formed on the back surface of the substrate 11 that has been thinned down, and the semiconductor laser 1 is completed.

### [Operations]

In this semiconductor laser 1, when a predetermined voltage is applied between the electrode 16 and the electrode (not illustrated) provided on the back surface of the substrate 11, an electric current confined by the current confinement layer 14 is injected into the active layer 13b through the first current injection region 14AE or the second current injection region 14BE. Thus, light is emitted by electron-hole recombination. This light is reflected between the first light reflection layer 12 and the second light reflection layer 15, and travels back and forth therebetween, which causes laser oscillation at a predetermined wavelength and is extracted as laser light from the side of the second light reflection layer 15. In the semiconductor laser 1, light outputted from the emission regions 10AE of the first mesa regions 10A and light outputted from the emission regions 10BE of the second mesa regions 10B are superimposed and extracted.

### [Workings and Effects]

In the semiconductor laser 1 according to an embodiment of the present embodiment, of the plurality of emission regions (the emission regions 10AE and 10BE), some emission regions (the emission regions 10BE) are provided with the phase shift section 10S; therefore, pieces of light of different far field patterns are extracted from the emission regions 10AE and 10BE. In this way, by superimposing and outputting the pieces of light of different far field patterns, it becomes possible to reduce the difference in light intensities depending on the directions of radiation angles. The following describes about this.

Semiconductor lasers are expected to serve, for example, as a light source for sensing as well. It is necessary that a light source for sensing maintain the magnitude of light intensity over a broad range of the directions of radiation angles. Thus, it is considered that an emission region may be made larger. However, when the emission region is made larger, multi-mode oscillation occurs, thus the planar shape of a far field pattern is likely to deviate from an ideal circular shape due to oscillation of higher-order mode.

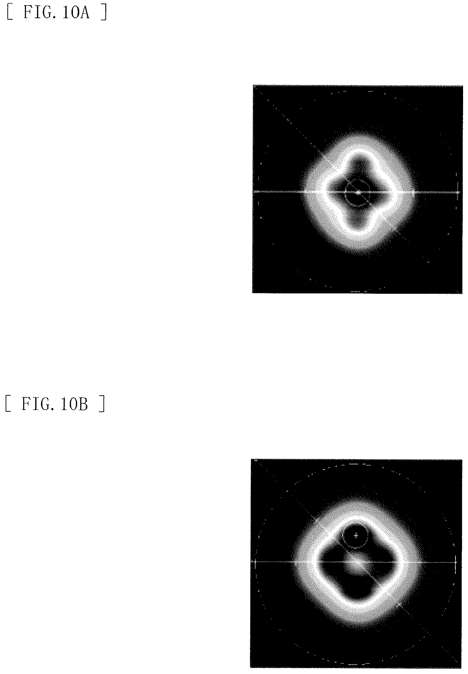

FIGs. 10A and 10B illustrate an example of a far field pattern of multi-mode light. Besides oscillation of higher-order mode, the shape of a current injection region of an oxide confinement layer, the crystal orientation of a substrate, etc. also affect a far field pattern. Thus, the planar shape of a far field pattern of light outputted from a large emission region is liable to be, for example, a cross shape or a quadrangular shape.

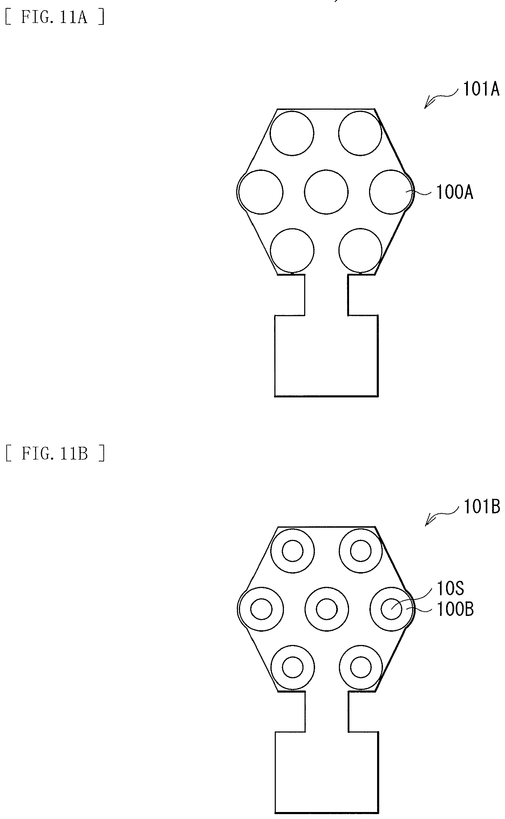

FIG. 11A illustrates a planar configuration of a semiconductor laser (a semiconductor laser 101A) having a plurality of small mesa regions (mesa regions 100A). In this semiconductor laser 101A, light of high single-mode nature is outputted from each mesa region 100A; however, its light intensity is liable to be limited in consideration of a burden on the eyes.

FIG. 11B illustrates a planar configuration of a semiconductor laser (a semiconductor laser 101B) in which each of mesa regions (mesa regions 100B) is provided with the phase shift section 10S. In this semiconductor laser 101B, by providing the phase shift section 10S, the single-mode nature is lessened, and higher-order mode light becomes dominant. Thus, the light intensity of a middle portion (a radiation angle of 0°) of an emission region may become too low.

Meanwhile, the semiconductor laser 1 according to the present embodiment has both the emission regions 10AE having the high single-mode nature and the emission regions 10BE having the lessened single-mode nature, and pieces of light of different far field patterns are outputted from the emission regions 10AE and 10BE. The pieces of light of the different far field patterns are superimposed and outputted.

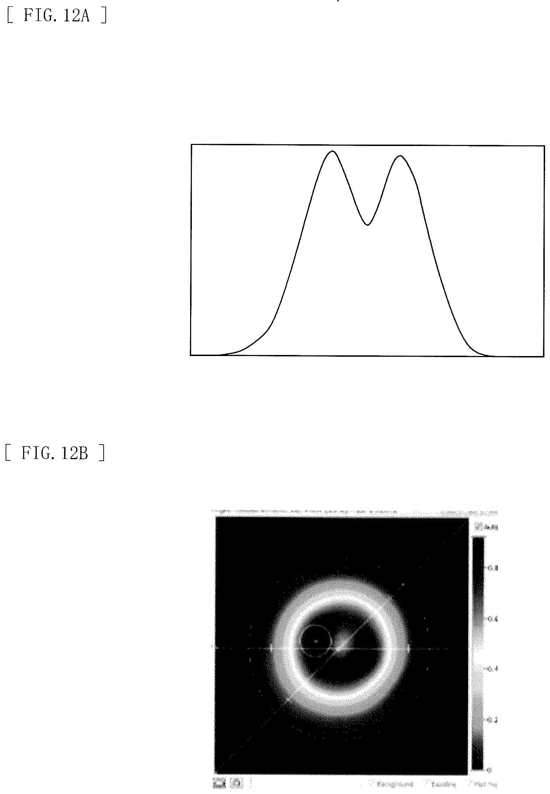

FIGs. 12A and 12B illustrate a far field pattern of light outputted from the semiconductor laser 1, namely, a far field pattern of superimposed light of respective pieces of light outputted from the emission regions 10AE and 10BE. In this way, by superimposing the pieces of light of different far field patterns, the uniform light intensity is maintained over a broad range of the directions of radiation angles.

As described above, in the present embodiment, the far field pattern of light outputted from the emission region 10AE and the far field pattern of light outputted from the emission region 10BE are made different; therefore, superimposition of respective pieces of light outputted from the emission regions 10AE and 10BE makes it possible to reduce the difference in light intensities depending on the directions of radiation angles. Accordingly, it is possible to bring an intensity distribution of a far field pattern closer to a uniform distribution. That is, the semiconductor laser 1 is able to stably achieve a uniform intensity distribution of a far field pattern regardless of manufacturing conditions, driving conditions, etc.

Furthermore, the phase shift section 10S is formed of the opening 17H of the first dielectric film 17a (FIG. 9B), and therefore is able to be easily formed in the same process as the first mesa region 10A that is not provided with the phase shift section 10S. That is, it is possible to improve the productivity of the semiconductor laser 1.

In the following, a modification example of the foregoing first embodiment and other embodiments are described; however, in the following description, the same component as in the foregoing embodiment is assigned the same reference numeral, and its description is omitted accordingly.

### [Modification Example]

The phase shift section 10S may be higher in reflectance on the side of the second light reflection layer 15 than the other portion of the emission region 10BE. At this time, for example, in the emission region 10BE, an optical film of the dielectric film (the first dielectric film 17a and the second dielectric film 17b) of the phase shift section 10S has a thickness of, for example, about an even multiple of λ/4, and an optical film of the dielectric film of the other portion has a thickness of, for example, about an odd multiple of λ/4.

Even in a case where such a phase shift section 10S is provided in the emission region 10BE, it is possible to make a far field pattern of light outputted from the emission region 10AE and a far field pattern of light outputted from the emission region 10BE different from each other.

### [Second Embodiment]

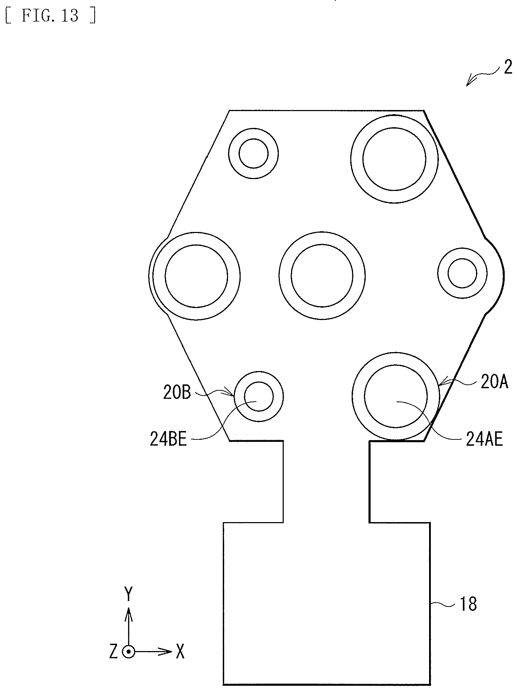

FIG. 13 schematically illustrates a planar configuration of a semiconductor laser (a semiconductor laser 2) according to a second embodiment of the present technology. The semiconductor laser 2 is provided with current injection regions (a first current injection region 24AE and a second current injection region 24BE) that differ in size from each other. For example, the first current injection region 24AE is larger, and the second current injection region 24BE is smaller. Except for this, the semiconductor laser 2 has a similar configuration to the semiconductor laser 1, and its workings and effects are also similar.

The first current injection region 24AE is provided in the current confinement layer 14 (FIG. 2A) of a first mesa region (a first mesa region 20A), and has a substantially circular planar shape. The diameter of the first current injection region 24AE is, for example, 12 µm to 14 µm. The first mesa region 20A has, for example, a substantially circular planar shape, and the diameter of the first mesa region 20A is, for example, 28 µm to 30 µm.

The second current injection region 24BE is provided in the current confinement layer 14 (FIG. 2B) of a second mesa region (a second mesa region 20B), and has a substantially circular planar shape. The diameter of the second current injection region 24BE is preferably, for example, 5 µm to 7 µm and smaller by 1 µm or more than the diameter of the first current injection region 24AE. In the present embodiment, the second current injection region 24BE is smaller than the first current injection region 24AE; therefore, a far field pattern of light generated in the smaller second current injection region 24BE is different from a far field pattern of light generated in the larger first current injection region 24AE.

The second mesa region 20B has, for example, a substantially circular planar shape, and has, for example, a smaller size than the first mesa region 20A. The diameter of the second mesa region 20B is, for example, 21 µm to 23 µm, and, for example, is smaller by 1 µm or more than the diameter of the first mesa region 20A.

The first current injection region 24AE and the second current injection region 24BE are formed, for example, as described in the foregoing first embodiment, by oxidizing a portion of the current confinement layer 14 from the periphery of each of the first and second mesa regions 20A and 20B. Therefore, for example, if the second mesa region 20B is caused to be smaller than the first mesa region 20A, the second current injection region 24BE is smaller than the first current injection region 24AE.

As with the above-described semiconductor laser 1, also in the semiconductor laser 2 of the present embodiment, a far field pattern of light generated in the first current injection region 24AE and a far field pattern of light generated in the second current injection region 24BE are different from each other; therefore, superimposition of respective pieces of light outputted from the first and second mesa regions 20A and 20B makes it possible to reduce the difference in light intensities depending on the directions of radiation angles. Accordingly, it is possible to bring an intensity distribution of a far field pattern closer to a uniform distribution.

Furthermore, the second mesa regions 20B having a different size from the first mesa regions 20A are able to be easily formed; therefore, it is possible to easily manufacture the semiconductor laser 2.

### [Third Embodiment]

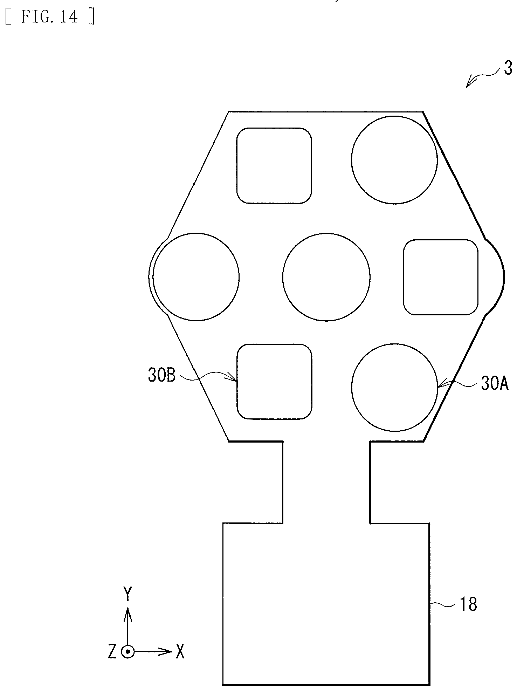

FIG. 14 schematically illustrates a planar configuration of a semiconductor laser (a semiconductor laser 3) according to a third embodiment of the present technology. The semiconductor laser 3 is provided with mesa regions (a first mesa region 30A and a second mesa region 30B) that differ in planar shape from each other. For example, the planar shape of the first mesa region 30A is substantially circular, and the planar shape of the second mesa region 30B is, for example, substantially square. Except for this, the semiconductor laser 3 has a similar configuration to the semiconductor laser 1, and its workings and effects are also similar.

FIG. 15A illustrates a planar configuration of the first mesa region 30A. The first mesa region 30A is provided with a first current injection region 34AE. The first current injection region 34AE is provided in the current confinement layer 14 (FIG. 2A) of the first mesa region 30A, and is formed, as described in the foregoing first embodiment, by oxidizing a portion of the current confinement layer 14 from the periphery of the first mesa region 30A.

The planar shape of the first current injection region 34AE is, for example, quadrangular. The planar shape of this first current injection region 34AE is attributed to, for example, the crystal plane orientation of the substrate 11 (FIG. 2A) as described above. Corners of the first current injection region 34AE are provided in predetermined directions (for example, X and Y directions in FIGs. 14 and 15A).

FIG. 15B illustrates an example of a far field pattern of light generated in the first current injection region 34AE. The planar shape of the far field pattern of light generated in the first current injection region 34AE is, for example, quadrangular under the influence of the planar shape of the first current injection region 34AE.

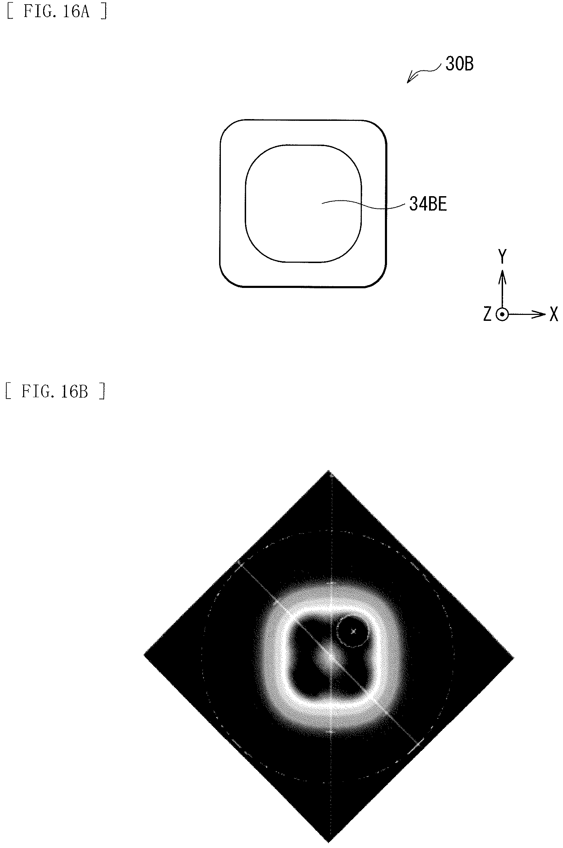

FIG. 16A illustrates a planar configuration of the second mesa region 30B. The second mesa region 30B is provided with a second current injection region 34BE. The second current injection region 34BE is provided in the current confinement layer 14 (FIG. 2B) of the second mesa region 30B, and is formed, as described in the foregoing first embodiment, by oxidizing a portion of the current confinement layer 14 from the periphery of the second mesa region 30B.

The planar shape of the second current injection region 34BE is, for example, a similar shape to the second mesa region 30B, and is substantially square. Corners of the second current injection region 34BE are provided, for example, in directions intersecting with the directions of the corners of the first current injection region 34AE (for example, directions between the X and Y directions in FIGs. 14 and 16A). For example, the directions of the corners of the second current injection region 34BE are provided to be at an angle of 45° to the directions of the corners of the first current injection region 34AE.

FIG. 16B illustrates an example of a far field pattern of light generated in the second current injection region 34BE. The planar shape of the far field pattern of light generated in the second current injection region 34BE is, for example, quadrangular under the influence of the planar shape of the second current injection region 34BE. Corners of the far field pattern are provided in directions intersecting with the corners of the far field pattern of light generated in the first current injection region 34AE.

In the present embodiment, the second mesa region 30B is configured to have a different planar shape from the first mesa region 30A; therefore, the second current injection region 34BE having a different planar shape from the first current injection region 34AE of the first mesa region 30A is formed in the second mesa region 30B. Accordingly, a far field pattern of light generated in the second current injection region 34BE is different from a far field pattern of light generated in the first current injection region 34AE.

For example, the far field pattern of light generated in the second current injection region 34BE and the far field pattern of light generated in the first current injection region 34AE differ in respective directions of their corners by 45°; therefore, the planar shape of a far field pattern generated by superimposition of these comes closer to a circular shape. Therefore, it becomes possible to reduce the difference in light intensities depending on radiation angles and to bring an intensity distribution of the far field pattern closer to a uniform distribution. The respective planar shapes of the first and second current injection regions 34AE and 34BE may be any shape, and may be, for example, a polygon other than a quadrangle.

FIG. 14 illustrates an example where the semiconductor laser 3 is provided with the first mesa region 30A and the second mesa region 30B that differ in their planar shapes; however, the semiconductor laser 3 may be further provided with one or more mesa regions having different planar shapes from the first mesa region 30A and the second mesa region 30B. By combining mesa regions of more different shapes, it becomes possible to bring an intensity distribution of a far field pattern closer to a uniform distribution.

Furthermore, the planar shape of the first mesa region 30A and the planar shape of the second mesa region 30B have to be different only when viewed from the same direction; for example, the planar shape of the first mesa region 30A and the planar shape of the second mesa region 30B may have a rotationally symmetric relationship.

As with the above-described semiconductor laser 3, also in the semiconductor laser 3 of the present embodiment, a far field pattern of light generated in the first current injection region 34AE and a far field pattern of light generated in the second current injection region 34BE are different from each other; therefore, superimposition of respective pieces of light outputted from the first mesa regions 30A and the second mesa regions 30B makes it possible to reduce the difference in light intensities depending on the directions of radiation angles. Accordingly, it is possible to bring an intensity distribution of a far field pattern closer to a uniform distribution.

Moreover, the second mesa regions 30B having a different planar shape from the first mesa regions 20A are able to be easily formed; therefore, it is possible to easily manufacture the semiconductor laser 3.

### [Application Example]

The semiconductor lasers 1, 2, and 3 (hereinafter, referred to collectively as the semiconductor laser 1) of the present technology are able to be suitably used as a light source for sensing because the difference in light intensities depending on radiation angles is small.

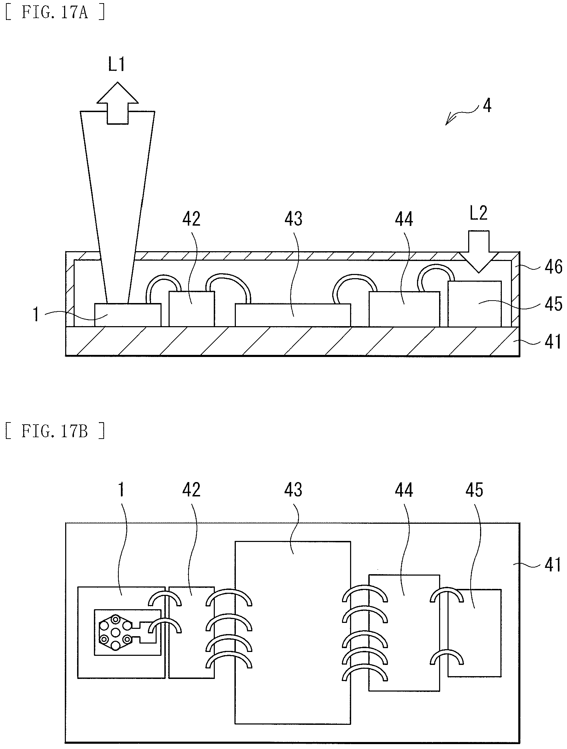

FIGs. 17A and 17B illustrate a schematic configuration of a sensing module (a sensing module 4) including the semiconductor laser 1. FIG. 17A illustrates a schematic cross-sectional configuration of the sensing module 4, and FIG. 17B illustrates a schematic planar configuration of the sensing module 4. The sensing module 4 is, for example, a distance sensor that measures the distance to an object.

The sensing module 4 includes, for example, the semiconductor laser 1, a laser driver 42, a signal processor 43, a signal amplifier 44, and a detector 45 on a wiring substrate 41, and these are housed in a chassis 46.

First, when having received a driving signal from the signal processor 43, the laser driver 42 drives the semiconductor laser 1. Thus, light L1 is outputted from the semiconductor laser 1. If the light L1 hits the object, the light L1 is reflected, and, as light L2, enters the detector 45 that includes, for example, a photodiode or the like. The light that has entered the detector 45 is converted into an electrical signal and amplified by the signal amplifier 44. The signal processor 43 uses this amplified electrical signal to calculate the distance to the object.

In the above, the present technology is described with some embodiments; however, the present technology is not limited to the above-described embodiments, and may be modified in a variety of ways. For example, respective components of the semiconductor lasers 1, 2, and 3 exemplified in the above-described embodiments, their layout and number, etc. are merely an example, and the semiconductor lasers 1, 2, and 3 do not have to include all the components, and may further include other components. For example, in the above-described first embodiment, there is described a case where the phase shift section 10S is provided in the middle portion of the emission region 10BE; however, the phase shift section 10S may be disposed at a position shifted from the middle portion of the emission region 10BE.

Furthermore, in the above-described first embodiment, there is described a case where the emission region 10AE is not provided with a phase shift section; however, both the emission regions 10AE and 10BE may each be provided with a phase shift section, and the respective phase shift sections may have different configurations from each other. This makes it possible to make a far field pattern of light outputted from the emission region 10AE and a far field pattern of light outputted from the emission region 10BE different from each other.

Moreover, in the above-described first embodiment, there is described a case where the phase shift section 10S is formed by adjusting the thickness of the dielectric film on the second light reflection layer 15; however, the phase shift section 10S may have another configuration.

In addition, the above-described first to third embodiments may be combined. For example, the first mesa regions 20A and 30A and the second mesa regions 20B and 30B may each be provided with a phase shift section, or the second mesa region 20B may be configured to have a different planar shape from the first mesa region 20A.

It is to be noted that the effects described in the present specification are merely exemplary and not limitative, and there may be other effects as well.

It is to be noted that the present technology may have the following configurations.
(1) A surface-emitting semiconductor laser including:
   a first emission region that outputs first light; and
   a second emission region that is provided separately from the first emission region, includes a phase shift section, and outputs second light,
   a far field pattern of the first light and a far field pattern of the second light being different from each other.
(2) The surface-emitting semiconductor laser according to (1), in which the first emission region and the second emission region each include a first light reflection layer, a semiconductor layer, and a second light reflection layer in the stated order.
(3) The surface-emitting semiconductor laser according to (2), in which reflectance on a side of the second light reflection layer differs between the phase shift section of the second emission region and another portion of the second emission region.
(4) The surface-emitting semiconductor laser according to (2) or (3), in which the phase shift section is provided in a middle portion of the second emission region.
(5) The surface-emitting semiconductor laser according to any one of (2) to (4), in which reflectance of the phase shift section on a side of the second light reflection layer is lower than reflectance of another portion of the second emission region on the side of the second light reflection layer.
(6) The surface-emitting semiconductor laser according to (5), in which
   the second emission region further includes a dielectric film stacked on the second light reflection layer,
   the dielectric film of the phase shift section has an optical film thickness of an odd multiple of one-fourth of a wavelength λ of the first light and the second light, and
   the dielectric film of the other portion of the second emission region has an optical film thickness of an even multiple of one-fourth of the wavelength λ.
(7) The surface-emitting semiconductor laser according to any one of (2) to (4), in which reflectance of the phase shift section on a side of the second light reflection layer is higher than reflectance of another portion of the second emission region on the side of the second light reflection layer.
(8) The surface-emitting semiconductor laser according to any one of (2) to (7), in which the first emission region is uniform in reflectance on a side of the second light reflection layer.
(9) A surface-emitting semiconductor laser including:
   a first current injection region; and
   a second current injection region that is provided separately from the first current injection region, and has a size different from a size of the first current injection region,
   a far field pattern of first light outputted from the first current injection region and a far field pattern of second light outputted from the second current injection region being different from each other.
(10) The surface-emitting semiconductor laser according to (9), in which
   respective planar shapes of the first current injection region and the second current injection region are each substantially circular, and
   the first current injection region and the second current injection region differ in diameter by 1 µm or more.
(11) The surface-emitting semiconductor laser according to (9) or (10), further including:
   a first mesa region provided with the first current injection region; and
   a second mesa region provided with the second current injection region and has a size different from a size of the first mesa region.
(12) The surface-emitting semiconductor laser according to (11), in which
   the first mesa region includes a first light reflection layer, a semiconductor layer, a current confinement layer, and a second light reflection layer in the stated order, and the second mesa region includes a first light reflection layer, a semiconductor layer, a current confinement layer, and a second light reflection layer in the stated order, and
   the first current injection region and the second current injection region are provided in the respective current confinement layers.
(13) The surface-emitting semiconductor laser according to (11) or (12), in which
   respective planar shapes of the first mesa region and the second mesa region are each substantially circular, and
   the first mesa region and the second mesa region differ in diameter by 1 µm or more.
(14) A surface-emitting semiconductor laser including:
   a first mesa region that is provided with a first current injection region, and outputs first light; and
   a second mesa region that is provided with a second current injection region, has a planar shape different from a planar shape of the first mesa region, and outputs second light,
   a far field pattern of the first light and a far field pattern of the second light being different from each other.
(15) The surface-emitting semiconductor laser according to (14), in which
   respective planar shapes of the first current injection region and the second current injection region are each a polygon, and
   respective directions of corners of the second current injection region are provided to be directions intersecting with respective directions of corners of the first current injection region.
(16) The surface-emitting semiconductor laser according to (14) or (15), in which
   a planar shape of the first mesa region is substantially circular, and
   a planar shape of the second mesa region is substantially quadrangular.
(17) The surface-emitting semiconductor laser according to any one of (14) to (16), in which
   the first mesa region includes a first light reflection layer, a semiconductor layer, a current confinement layer, and a second light reflection layer in the stated order, and the second mesa region includes a first light reflection layer, a semiconductor layer, a current confinement layer, and a second light reflection layer in the stated order, and
   the first current injection region and the second current injection region are provided in the respective current confinement layers.
(18) A sensing module including a surface-emitting semiconductor laser,
   the surface-emitting semiconductor laser including
   a first emission region that outputs first light, and
   a second emission region that is provided separately from the first emission region, includes a phase shift section, and outputs second light,
   a far field pattern of the first light and a far field pattern of the second light being different from each other.
(19) A sensing module including a surface-emitting semiconductor laser,
   the surface-emitting semiconductor laser including
   a first current injection region, and
   a second current injection region that is provided separately from the first current injection region, and has a size different from a size of the first current injection region,
   a far field pattern of first light outputted from the first current injection region and a far field pattern of second light outputted from the second current injection region being different from each other.
(20) A sensing module including a surface-emitting semiconductor laser,
   the surface-emitting semiconductor laser including
   a first mesa region that is provided with a first current injection region, and outputs first light, and
   a second mesa region that is provided with a second current injection region, has a planar shape different from a planar shape of the first mesa region, and outputs second light,
   a far field pattern of the first light and a far field pattern of the second light being different from each other.

This application claims the benefit of Japanese Priority Patent Application JP2017-117852 filed with the Japan Patent Office on June 15, 2017, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A surface-emitting semiconductor laser comprising:
a first emission region that outputs first light; and
a second emission region that is provided separately from the first emission region, includes a phase shift section, and outputs second light,
a far field pattern of the first light and a far field pattern of the second light being different from each other.

2. The surface-emitting semiconductor laser according to claim 1, wherein the first emission region and the second emission region each include a first light reflection layer, a semiconductor layer, and a second light reflection layer in the stated order.

3. The surface-emitting semiconductor laser according to claim 2, wherein reflectance on a side of the second light reflection layer differs between the phase shift section of the second emission region and another portion of the second emission region.

4. The surface-emitting semiconductor laser according to claim 2, wherein the phase shift section is provided in a middle portion of the second emission region.

5. The surface-emitting semiconductor laser according to claim 2, wherein reflectance of the phase shift section on a side of the second light reflection layer is lower than reflectance of another portion of the second emission region on the side of the second light reflection layer.

6. The surface-emitting semiconductor laser according to claim 5, wherein
the second emission region further includes a dielectric film stacked on the second light reflection layer,
the dielectric film of the phase shift section has an optical film thickness of an odd multiple of one-fourth of a wavelength λ of the first light and the second light, and
the dielectric film of the other portion of the second emission region has an optical film thickness of an even multiple of one-fourth of the wavelength λ.

7. The surface-emitting semiconductor laser according to claim 2, wherein reflectance of the phase shift section on a side of the second light reflection layer is higher than reflectance of another portion of the second emission region on the side of the second light reflection layer.

8. The surface-emitting semiconductor laser according to claim 2, wherein the first emission region is uniform in reflectance on a side of the second light reflection layer.

9. A surface-emitting semiconductor laser comprising:
a first current injection region; and
a second current injection region that is provided separately from the first current injection region, and has a size different from a size of the first current injection region,
a far field pattern of first light outputted from the first current injection region and a far field pattern of second light outputted from the second current injection region being different from each other.

10. The surface-emitting semiconductor laser according to claim 9, wherein
respective planar shapes of the first current injection region and the second current injection region are each substantially circular, and
the first current injection region and the second current injection region differ in diameter by 1 µm or more.

11. The surface-emitting semiconductor laser according to claim 9, further comprising:
a first mesa region provided with the first current injection region; and
a second mesa region provided with the second current injection region and has a size different from a size of the first mesa region.

12. The surface-emitting semiconductor laser according to claim 11, wherein
the first mesa region includes a first light reflection layer, a semiconductor layer, a current confinement layer, and a second light reflection layer in the stated order, and the second mesa region includes a first light reflection layer, a semiconductor layer, a current confinement layer, and a second light reflection layer in the stated order, and
the first current injection region and the second current injection region are provided in the respective current confinement layers.

13. The surface-emitting semiconductor laser according to claim 11, wherein
respective planar shapes of the first mesa region and the second mesa region are each substantially circular, and
the first mesa region and the second mesa region differ in diameter by 1 µm or more.

14. A surface-emitting semiconductor laser comprising:
a first mesa region that is provided with a first current injection region, and outputs first light; and
a second mesa region that is provided with a second current injection region, has a planar shape different from a planar shape of the first mesa region, and outputs second light,
a far field pattern of the first light and a far field pattern of the second light being different from each other.

15. The surface-emitting semiconductor laser according to claim 14, wherein
respective planar shapes of the first current injection region and the second current injection region are each a polygon, and
respective directions of corners of the second current injection region are provided to be directions intersecting with respective directions of corners of the first current injection region.

16. The surface-emitting semiconductor laser according to claim 14, wherein
a planar shape of the first mesa region is substantially circular, and
a planar shape of the second mesa region is substantially quadrangular.

17. The surface-emitting semiconductor laser according to claim 14, wherein
the first mesa region includes a first light reflection layer, a semiconductor layer, a current confinement layer, and a second light reflection layer in the stated order, and the second mesa region includes a first light reflection layer, a semiconductor layer, a current confinement layer, and a second light reflection layer in the stated order, and
the first current injection region and the second current injection region are provided in the respective current confinement layers.

18. A sensing module comprising a surface-emitting semiconductor laser,
the surface-emitting semiconductor laser including
a first emission region that outputs first light, and
a second emission region that is provided separately from the first emission region, includes a phase shift section, and outputs second light,
a far field pattern of the first light and a far field pattern of the second light being different from each other.

19. A sensing module comprising a surface-emitting semiconductor laser,
the surface-emitting semiconductor laser including
a first current injection region, and
a second current injection region that is provided separately from the first current injection region, and has a size different from a size of the first current injection region,
a far field pattern of first light outputted from the first current injection region and a far field pattern of second light outputted from the second current injection region being different from each other.

20. A sensing module comprising a surface-emitting semiconductor laser,
the surface-emitting semiconductor laser including
a first mesa region that is provided with a first current injection region, and outputs first light, and
a second mesa region that is provided with a second current injection region, has a planar shape different from a planar shape of the first mesa region, and outputs second light,
a far field pattern of the first light and a far field pattern of the second light being different from each other.
